Europäisches Patentamt

European Patent Office

Office européen des brevets

(11) Veröffentlichungsnummer: **0 317 748**
**A2**

## (12) EUROPÄISCHE PATENTANMELDUNG

(21) Anmeldenummer: 88116755.5

(22) Anmeldetag: 10.10.88

(51) Int. Cl.⁴: **C23C 18/26**

(30) Priorität: 25.11.87 DE 3740369

(43) Veröffentlichungstag der Anmeldung:
31.05.89 Patentblatt 89/22

(84) Benannte Vertragsstaaten:
BE CH DE ES FR GB IT LI LU NL SE

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Römer, Michael, Dr.**
**Popitzweg 7**
**D-1000 Berlin 13(DE)**
Erfinder: **Stein, Ludwig**
**Querstrasse 5**
**D-1000 Berlin 37(DE)**

(54) Verfahren zur Vorbehandlung von Kunststoffen.

(57) Die Erfindung betrifft ein Verfahren zur Vorbehandlung von Kunststoffen, insbesondere von Polyetherimid, Polycarbonat und Poly(ester-co-carbonat), für die haftfeste chemische Metallisierung, dadurch gekennzeichnet, daß die Kunststoffe mit einer quaternären Base gelöst in einem organischen Lösungsmittel behandelt werden.

EP 0 317 748 A2

## VERFAHREN ZUR VORBEHANDLUNG VON KUNSTSTOFFEN

Die Erfindung betrifft ein Verfahren zur Vorbehandlung von Kunststoffen, insbesondere von Polyetherimid, Polycarbonat und Poly(ester-CO-carbonat), für die haftfeste chemische Metallisierung.

Unter Vorbehandlung wird die Vorbereitung oder Veränderung der Kunststoffoberflächen einschließlich der Füllstoffe (zum Beispiel Glasfaser) verstanden, mit dem Ziel, die Aktivierung (Bekeimung) vollständig und gleichmäßig zu gewährleisten und damit die chemische Metallisierung positiv zu beeinflussen.

Die Vorbehandlung von Kunststoffen auf Basis von Polyestern, Polyamiden, Polysulfonen, Polyurethanen unter anderem für die chemische Metallisierung ist bereits bekannt. Hierzu gehören zum Beispiel die Behandlung mittels alkalischer Reiniger, mittels $SO_3$ in der Gasphase, mittels netzmittelhaltige Lösungsmittel oder mittels wasserlöslicher organischer Lösungsvermittler, die Hydroxylionen solvatisieren.

Für die Vorbehandlung von Kunststoffen auf Basis von Polyetherimiden, Polycarbonaten und Poly(ester-CO-carbonaten) sind diese Behandlungsverfahren jedoch ungeeignet, da sie nur eine unbefriedigende Haftfestigkeit der abgeschiedenen Metallschichten bewirken.

Aufgabe der vorliegenden Erfindung ist die Zurverfügungstellung eines Vorbehandlungsverfahrens für Kunststoffe der oben genannten Art, welches eine haftfeste chemische Metallisierung ermöglicht.

Diese Aufgabe wird gelöst durch ein Verfahren gemäß dem kennzeichnenden Merkmal des Patentanspruchs.

Vorteilhafte Ausführungsformen sind in den Unteransprüchen beschrieben.

Das erfindungsgemäße Verfahren ermöglicht in besonders vorteilhafter Weise eine haftfeste Metallisierung von Kunststoffoberflächen.

So werden die Kunststoffe überraschenderweise stark hydrophiliert und damit in besonderer Weise für die Aktivierung vorbereitet, wobei gleichzeitig die Oberflächen aufgequollen und der Angriff des Ätzmediums erleichtert und somit verstärkt wird.

Ein besonderer überraschender Vorteil besteht weiterhin darin, daß die derart behandelnden Oberflächen keine Mikrorauhigkeit aufweisen, was die elektrischen Oberflächeneigenschaften positiv beeinflußt.

Als Polyetherimid wird ein thermoplastisches aromatisches Ethergruppen enthaltendes Polyimid verstanden, welches periodisch wiederkehrende aromatische und aromatische substituierte Phthalsäureimidgruppen in der Kette enthält.

Als Polycarbonate werden solche Kunststoffe bezeichnet, die üblicherweise aus substituierten oder unsubstituierten Bisphenol A und Phosgen synthetisiert werden.

Poly(ester-co-carbonate) werden als weiterentwickelte Polycarbonate angesehen, die aus den langen Bisphenol A-PC-Segmenten und kürzeren Bisphenol A-Ethylen-oder Butylenterephthalat-Segmenten bestehen.

Diese Kunststoffe können gewünschtenfalls einen Glasfaseranteil oder Mineralanteil enthalten.

Als erfindungsgemäß zu verwendende quaternären Basen sind insbesondere zu nennen
Ammoniumhydroxid,
Alkylammoniumhydroxid,
Arylammoniumhydroxid,
Vinyltriarylphosphoniumhydroxid,
Tetraphenylphosphoniumhydroxid und
Tetraphenylarsoniumhydroxid.

Eine herausragende Wirkung entfaltet weiterhin das Tetramethylammoniumhydroxid.

Geeignete Verbindungen sind außerdem die folgenden Basen beziehungsweise deren Salze, die gemeinsam mit Hydroxylionen verwendet werden:
Alkylbenzyldimethylammonium chlorid
(-)-N-Benzylquininium chlorid
Benzyltributylammonium bromid
Benzyltributylammonium chlorid
Benzyltriethylammonium chlorid
Benzyltriethylammonium hydroxid
Benzyltrimethylammonium chlorid
Benzyltrimethylammonium hydroxid
Benzyltrimethylammonium hydroxid
Butyltriphenylphosphonium chlorid
(-)-N-Dodecyl-N-methylephedrinium bromid
Ethylhexadecyldimethylammonium bromid
Ethyltrioctylphosphonium bromid
Hexadecyltrimethylammonium bromid
Hexadecyltrimethylammonium chlorid
Methyltrioctylammonium chlorid
Tetrabutylammonium fluorid trihydrat
Tetrabutylammonium hydrogen sulfat
Tetrabutylammonium hydroxid
Tetrabutylammonium hydroxid
Tetrabutylammonium iodid
Tetrabutylammonium tetrafluoroborat
Tetrabutylphosphonium bromid
Tetrabutylphosphonium chlorid
Tetraethylammonium bromid
Tetraethylammonium chlorid
Tetraethylammonium cyanid
Tetraethylammonium hydroxid
Tetraethylammonium fluoroborat
Tetraoctylammonium bromid
Tetraphenylphosphonium bromid

Tetraphenylphosphonium chlorid
Tetrapropylammonium bromid
Tributylhexadecylphosphonium bromid
Tributylmethylammonium chlorid
Tetrapentylammonium bromid
Tetramethylammonium hydroxid
Tetrapropylammoinum hydroxid (wässrige Lösung)
Tetrahexylammonium bromid
Tetradecyltrimethylammonium bromid
Methyltridecylammonium chlorid

Die Anwendung dieser Verbindungen erfolgt in Konzentration von 0,05 bis 200 g/Liter.

Es versteht sich, daß die erfindungsgemäßen Vorbehandlungsmittel als solche in originärer Form oder - falls gewünscht - in Form ihrer Salze in Gegenwart von Hydroxylionen verwendet werden können, aus denen die quaternären Basen in Gegenwart von Hydroxylionen freigesetzt werden.

Als organische Lösungsmittel beziehungsweise lösungsvermittelnde Medien sind beispielsweise die folgenden zu nennen.

N-Methyl formamid

N-Methyl acetamid

Propylencarbonat

Ethylencarbonat

Acetonitril

Dimethylsulfoxid

N,N-Dimethylformamid

Dimethylacetamid

N-Methyl pyrrolidon

Methylenchlorid

Essigsäureethylester

1,4-Dioxan

Diethylcarbonat

$\gamma$-Butyrolacton

Ethylenglycol

Ethylenglycolmonomethylether

Ethylenglycolmonoethylether

Ethylenglycolmonobutylether

Ethylenglycolmonoisopropylether

Ethylenglycolmonoisobutylether

Ethylenglycolmono-tert-butylether

Ethylglycolmono-n-hexylether

Ethylenglycolmono(2-aminoethyl)-ether

Ethylenglycoldiglycidylether

Ethylenglycolmonophenylether

Ethylenglycolmonoacetat

Ethylenglycoldiacetat

Ethylenglycolmonoethylether-acetat

Ethylenglycolmonoallylether

Ethylenglycoldimethylether

Ethylenglycolmonobutylether-acetat

Ethylenglycolmonobenzylether

Ethylenglycolmonoisoamylether

Methanol

Ethanol

n-Propanol

i-Propanol

n-Butanol

Glycerin

Glycerinaldehyd

Glyceringlycid

Glycerinmonomethylether

Glycerinmonoethylether

Diethylenglycol

Diethylenglycolmonomethylether

Diethylenglycolmonoethylether

Diethylenmonobutylether

Diethylendiethylether

Diethylenglycoldimethylether

Triethylenglycol

Triethylenglycolmonomethylether

Triethylenglycolmonoethylether

Die Lösungsmittel werden zweckmäßigerweise in Anwendungskonzentrationen von 10 bis 100 Gewichtsprozent verwendet.

Gewünschtenfalls kann eine Mischung dieser Lösungsmittel mit Wasser erfolgen.

Die erfindungsgemäß zu verwendenden Lösungen sind alkalisch und weisen einen pH- Wert von 13 bis 14 auf.

Die Behandlung der Kunststoffe erfolgt zweckmäßigerweise bei Temperaturen von 15 bis 30° C, vorzugsweise 25° C.

Die Durchführung des erfindungsgemäßen Verfahrens erfolgt durch übliches Tauchen der Kunststoffwerkstücke, wie Folien, Spritzteile, kupferlaminierte extrudierte Platten oder Formteile, in die erfindungsgemäße Vorbehandlungslösung.

Die Behandlungszeit richtet sich nach dem jeweiligen Kunststoff und beträgt in der Regel 3 bis 10 Minuten, vorzugsweise 5 Minuten. Die vorbehandelten Teile werden dann gespült und können dann weiterbearbeitet werden. Von einem derart vorbehandelten Werkstück perlt Wasser nicht mehr ab.

Die Aktivierung und chemische Metallisierung der erfindungsgemäß vorbehandelten Kunststoffwerkstücke erfolgt in an sich bekannter Weise.

Die Aktivierung kann zum Beispiel mittels eines Palladium-Aktivators erfolgen, der in ionogener Form oder in Form kolloidaler Partikel vorliegt. Gegebenenfalls werden die Palladiumionen auf der Substratoberfläche reduziert, zum Beispiel durch Einwirkung von Dimethylaminoboran oder Natriumborhydrid. Kolloidale Palladiumkeime können mittels Borfluorwasserstoffsäure oder Natronlauge von ihrem Schutzkolloid befreit werden.

Die so vorbehandelten Oberflächen werden nun nach üblichen Verfahren chemisch metallisiert, und zwar unter Verwendung stromloser Nickel-, Kobalt-, Silber-, Zinn-,Gold- oder Kupferbäder. Der zum Beispiel chemisch verkupferte oder vernickelte Kunststoffkörper kann zwecks Verbundverstärkung einer Temperung von 80 bis 120° C unterworfen werden, um gegebenenfalls Wasser oder Lösungsmittel zu entfernen, was etwa eine Stunde dauern kann.

Je nach Anforderungsprofil der metallisierten Kunststoffkörper kann die Schichtdicke des Metalls chemisch oder galvanisch verstärkt und nach üblichen Strukturierungsverfahren bearbeitet werden. Der Verbund Metall-Kunststoff zeichnet sich durch seine große Stabilität und Haftfestigkeit der Metallschicht auf der Substratoberfläche aus.

Das erfindungsgemäße Verfahren läßt sich insbesondere zur Herstellung von Leiterplatten in der Elektrotechnik und Elektronik anwenden.

Derart hergestellte Leiterplatten haben den besonderen Vorteil einer geringen Mikrorauhigkeit und hoher Haftfestigkeit, was von großem Vorteil ist.

Eine besonders gute Haftung auch nach dem Lötübergang läßt sich erzielen, wenn die Kunststoffe noch nach erfolgter Vorbehandlung mittels eines Ätzbades, vorzugsweise mittels eines Bades enthaltend eines saures Oxydationsmittel aufgerauht und dann in üblicher Weise weiterbehandelt werden. Als saure Oxydationsmittel kann außer Chromschwefelsäure auch Chlorsäure, Wasserstoffperoxid und Peroxidischwefelsäure verwendet werden.

Die erfindungsgemäße bekannten Kunststoffwerkstücke weisen außerordentlich hohe Haftwerte bis zu 20 N/cm auf.

Die folgenden Beispiele dienen zur Erläuterung der Erfindung.

## BEISPIEL 1

Eine Polyetherimidplatte mit 20% Glasfaseranteil wird in einer Lösung von 40 g/Liter Tetraethylammoniumhydroxid in Diethylenglycolmonobutylether /N-Methyl-pyrrolidon (60 : 40) 5 Minuten bei Raumtemperatur getaucht, anschließend gespült und dann 5 Minuten bei Raumtemperatur in eine üblichen alkalischen Reiniger zur Leiterplattenmetallisierung getaucht.

Anschließend wird die Platte gespült und in einem Palladium-Aktivator aktiviert und die Palladiumionen dann in einem Reduktionsbad zu Palladiummetall reduziert. Nachfolgend wird die so vorbehandelte Platte in einem chemisch reduktiven Kupferbad mit einer dünnen Kupferschicht versehen, getempert und galvanisch auf 35 μm Schichtdicke mit Kupfer verstärkte und anschließend 2 Stunden bei 132° C getempert. Der Haftwert gemessen nach DIN-Norm 53 494 beträgt 12-13 N/cm vor dem Löten und nach dem Tauchen der Platte für 5 Sekunden in ein 265° C heißes Lötzinnbleibad 10 N/cm.

## BEISPIEL 2

Eine Polyetherimidplatte mit 20% Glasfaseranteil wird nach dem Trocknen und Entstressen von 4 Stunden bei 160° C 5 Minuten lang in eine 50° C heiße Lösung, bestehend aus 80 g/Liter Tetramethylammoniumhydroxid, 900 ml Acetonitril, 50 ml Methanol und 50 ml Wasser behandelt. Die Platte wird anschließend 3 Minuten gespült und wie im Beispiel 1 beschrieben alkalisch gereinigt, aktiviert, chemisch und galvanisch metallisiert und getempert. Der Haftwert - wie im Beispiel 1 bestimmt - beträgt 12 - 13 N/cm vor dem Löten und nach dem Tauchen der Platte für 5 Sekunden in ein 265° C heißes Lötzinnbleibad 10 N/cm.

## BEISPIEL 3

Polyetherimidplatten mit 20% Glasfaseranteil werden in Lösungen - wie in Beispiel 2 beschrieben - behandelt, die anstelle von Acetonitril folgende organische Verbindungen im selben Konzentrationsbereich enthalten.

a) 900 ml N,N-Dimethylacetamid
b) 900 ml N-Methylpyrrolidon
c) 900 ml N,N-Dimethylformamid

Die Polyetherimidplatten werden anschließend gespült und analog zu Beispiel 2 weiterbearbeitet. Die Haftwerte - gemessen nach Peel Test-DIN-Norm - sind aus der folgenden Tabelle ersichtlich:

a) N,N-Dimethylacetamid      20 N/cM
b) N-Methylpyrrolidon        20 N/cm
c) N,N-Dimethylformamid      15 N/cm

## BEISPIEL 4

Je eine Polycarbonatplatte mit $TiO_2$-Pigmentierung wird 5 Minuten lang in eine 50° C heiße Lösung, bestehend aus
a) 40 g / Liter Tetramethylammoniumhydroxid
800 ml Ethylenglycolmonobutylether
150 ml N,N-Dimethylacetamid
50 ml Wasser
oder
40 g / Liter Tetramethylammoniumhydroxid
800 ml Diethylenglycolmonobutylether
150 ml Diethylcarbonat
50 ml Wasser
behandelt.

Nach dem 3-minütigen Spülen in Wasser werden die Platten in eine übliche schwefelsaure Chrom VI-oxid-Beize getaucht, 2 Minuten gespült und das noch auf der Substratoberfläche befindliche sechswertige Chrom mittels einer 2%igen wässrigen NaHSO₃-Lösung zu Chrom-III reduziert.

Die Substratoberfläche der Platten ist nach der Behandlung in beiden Beispielen schwach aufgerauht und zeigt eine gute Benetzung mit Wasser. Beide Platten werden wie im Beispiel 1 beschrieben mit einem Palladiumaktivator aktiviert und abschließend in einem üblichen Dickkupferbad auf 1 μm Shichtdicke chemisch verkupfert. Nach dem Tempern der Polycarbonatplatten eine Stunde lang bei 100° C besteht die jeweilige Kupferschicht in ihrem Haftwert den Tesa-Test.

BEISPIEL 5

Eine Poly(ester-co-carbonat)-Platte wird in einer Lösung 2 Minuten bei Raumtemperatur behandelt, die 20 g/Liter Kaliumhydroxid und 20g/Liter Tetraphenylphosphoniumbromid gelöst in 950 ml Diethylenglycolmonomethylether enthält. Die Platte wird 3 Minuten in Wasser gespült, alkalisch gereinigt, mit Palladiumkeimen aktiviert, chemisch und galvanisch mit Kupfer verstärkt und getempert in der Art und Weise wie in Beispiel 1 beschrieben. Der Tesa-Test wurde nach einstündigem Tempern der metallisierten Platte bei 100° C bestanden.

Eine analog behandelte Platte aus einem Polyetherimid mit 20% Glasfaseranteil weist einen Haftwert nach DIN-Norm von 16 N/cm vor dem Löten und 13 N/cm nach Tauchen der Probe 5 Sekunden lang in ein 265° C heißes Lot auf.

BEISPIEL 6

Eine Polyetherimidplatte mit 20% Glasfaseranteil wird in eine Lösung bestehend aus 80 g/Liter Tetramethylammoniumhydroxid und 400 ml Diethylenglycolmonobutylether 5 Minuten getaucht, gespült und analog wie in Beispiel 1 bis zu einer Schichtdicke von 35 μm Kupfer aufgebaut. Die Haftung nach DIN-Norm gemessen, beträgt 14 N/cm.

BEISPIEL 7

Eine Polyetherimidplatte mit 20% Glasfaseranteil wird in eine Lösung bestehend aus 60 g Tetramethylammoniumhydroxid, 400 ml Ethylenglycolmonobutylether, 400 ml Dimethylsulfoxid und 200 ml Methanol 5 Minuten getaucht, gespült und analog wie in Beispiel 1 auf 35 μm Kupfer aufgebaut. Die Haftung nach DIN-Norm gemessen beträgt 20 N/cm.

BEISPIEL 8

Eine Polyetherimidplatte mit 20% Glasfaseranteil wird

a) 5 Minuten lang in eine Lösung aus 80 g/Liter Tetramethylammoniumhydroxid in Diethylenglycolmonobutylether oder

b) 3 Minuten lang in eine Lösung auf 60 g Tetramethylammoniumhydroxid in 400 ml Dimethylsulfoxid und 200 ml Methanol

getaucht, anschließend 5 Minuten gespült und in eine Chrom-VI-oxid-Schwefelsäure-Beize 15 Minuten bei 65° C behandelt, 2 Minuten anschließend gespült und das noch überschüssige sechswertige Chrom mittels einer 10% wässrigen NaHSO₃-Lösung zu dreiwertigem Chrom reduziert. Die Substratoberfläche beider unterschiedlich behandelten Platten ist nicht wesentlich aufgerauht und zeigt ausgezeichnete Benetzung mit Wasser. Beide Platten werden wie im Beispiel 1 beschrieben mit Palladiumkeimen aktiviert und in einem üblichen chemischen Kupferbad auf 0,4 m Schichtdicke metallisiert, bei 100° C eine Stunde lang getempert und galvanisch mittels Kupfer auf 35 μm Schichtstärke ganzflächig aufgebaut. Nach abschließendem Tempern 2 Stunden lang bei 130° C wird aus den beiden Polyetherimidplatten ein 2,54 cm breiter Streifen herausgesägt und der Haftwert nach DIN-Standard bestimmt.

Die Haftwerte betragen für die Behandlung
a: 13,5 N/cm vor dem Löten und
b: 17 N/cm.

Nach dem Tauchen der Platten 5 Sekunden in ein 265° C heißes Lötbad beträgt die Haftung 12 N/cm (für a) und 15 N/cm (für b).

BEISPIEL 9

Eine Poly(ester-co-carbonat)-Platte, die ein Biegemodul von 1900 N/mm² aufweist, wird 2 Minuten lang in eine Lösung aus 8 g Tetramethylammoniumhydroxid in 400 ml Acetonitril, 400 ml Wasser und 200 ml Methanol getaucht, 3 Minuten gespült und 10 Minuten lang in eine übliche Chrom-Schwefelsäurebeize mit 380 g/Liter CrO₃ und 380 g/Liter Schwefelsäure konzentriert behandelt. Nach dem 2minütigen Spülen in Wasser und dem 3minütigen Tauchen in einer 10% Natriumhydrogensulfit-Lösung, nochmaligem 5minütigen Spülen wird die Poly(ester-co-carbonat)-Platte in einen üblichen sauren Palladium-Zinnchlorid-Aktivator getaucht, in üblicher Weise nachbehandelt, gespült und dann in einem chemischen Nickelbad bei 55° C mit 1 μm

Schichtdicke metallisiert.

Die so erhaltene ganzflächig vernickelte Platte wird nach dem Tempern 2 Stunden lang bei 130° C galvanisch mit Kupfer auf 35 μm Schichtdicke aufgebaut und der Haftwert nach DIN-Standard zu 10.6 N/cm bestimmt.

## Ansprüche

1. Verfahren zur Vorbehandlung von Kunststoffen, insbesondere von Polyetherimid, Polycarbonat und Poly(ester-Co-carbonat), für die haftfeste chemische Metallisierung, dadurch gekennzeichnet, daß die Kunststoffe mit einer quaternären Base gelöst in einem organischen Lösungsmittel behandelt werden.

2. Verfahren gemäß Anspruch 1, dadurch gekennzeichnet, daß als quaternäre Base ein quaternäres Ammonium-, Phosphonium- oder Arsoniumhydroxid verwendet wird.

3. Verfahren gemäß Ansprüchen 1 und 2, dadurch gekennzeichnet, daß als quaternäre Base ein $C_1$-$C_4$-Alkyl-ammoniumhydroxid, Arylammoniumhydroxid, Vinyltriarylphosphoniumhydroxid, Tetraphenylphosphoniumhydroxid oder Tetraphenylarsoniumhydroxid verwendet wird.

4. Verfahren gemäß Ansprüchen 1 bis 3, dadurch gekennzeichnet, daß als quaternäre Base Tetramethylammoniumhydroxid verwendet wird.

5. Verfahren gemäß Ansprüchen 1 bis 4, dadurch gekennzeichnet, daß die quaternären Basen aus ihren Salzen in Gegenwart von Hydroxylionen gebildet werden.

6. Verfahren gemäß Anspruch 5, dadurch gekennzeichnet, daß als Salze die Halogenide, Tetrafluoro(Hydro, Phenyl) Borate, Perjodate, Hydrosulfate, Dihydrogenphosphate oder Hexafluorophosphate verwendet werden.

7. Verfahren gemäß Anspruch 5, dadurch gekennzeichnet, daß die Hydroxylionen aus Alkalihydroxiden gebildet werden.

8. Verfahren gemäß Anspruch 1, dadurch gekennzeichnet, daß ein organisches Lösungsmittel verwendet wird, welches löslich ist in Wasser, Alkoholen oder Ethern.

9. Verfahren gemäß Anspruch 8, dadurch gekennzeichnet, daß das organische Lösungsmittel gleichzeitig ein Quellmittel für den Kunststoff ist.

10. Verfahren gemäß Ansprüchen 8 und 9, dadurch gekennzeichnet, daß als Lösungsmittel und/oder Quellmittel Alkylsulfoxide, Dialkylsulfoxide, Dialkylcarbonate, Dialkylacetamide, N,N-Dialkylformamide, Pyrrolidone, Alkohole und/oder Ether verwendet werden.

11. Verfahren gemäß Ansprüchen 8 bis 10, dadurch gekennzeichnet, daß die Lösungsmittel und/oder Quellmittel in Mischung mit Wasser verwendet werden.

12. Verfahren gemäß Anspruch 1, dadurch gekennzeichnet, daß die quaternäre Base in Konzentrationen von 0,05 bis 200 g/Liter verwendet werden.

13. Verfahren gemäß Anspruch 1, dadurch gekennzeichnet, daß das organische Lösungsmittel in Anwendungskonzentrationen von 10 bis 100 Gewichtsprozent verwendet wird.

14. Verfahren gemäß Anspruch 1, dadurch gekennzeichnet, daß die Behandlung bei Temperaturen von 15 bis 30° C, vorzugsweise 25° C, durchgeführt wird.

15. Verfahren gemäß Anspruch 1, dadurch gekennzeichnet, daß die Kunststoffe nach erfolgter Vorbehandlung mittels eines Ätzbades, vorzugsweise eines Bades enthaltend ein saures Oxydationsmittel, aufgerauht werden.

16. Verfahren gemäß Anspruch 15, gekennzeichnet durch die Verwendung eines schwefelsäuren Chrom-VI-oxid enthaltenden Ätzbades.

17. Verfahren gemäß Anspruch 1, dadurch gekennzeichnet, daß die Kunststoffe nach erfolgter Vorbehandlung, gegebenenfalls nach anschließender Aufrauhung in an sich bekannter Weise aktiviert und chemisch metallisiert werden.

18. Verfahren gemäß Anspruch 17, dadurch gekennzeichnet, daß die Aktivierung mittels einer Lösung enthaltend kolloidales oder ionogenes Palladium erfolgt, welches in an sich bekannter Weise vom Schutzkolloid befreit oder zum nullwertigen Metall reduziert wird.

19. Verfahren gemäß Anspruch 1, dadurch gekennzeichnet, daß die chemische Metallisierung mittels eines Kupfer-, Silber-, Gold-, Zinn-, Kobalt- und/oder Nickelbades erfolgt.

20. Verfahren gemäß Anspruch 1, dadurch gekennzeichnet, daß als Kunststoff auf Basis eines Polyetherimids ein amorphes aromatisches hochtemperaturbeständiges thermoplastisches Polyetherimid verwendet wird.

21. Verfahren gemäß Anspruch 1, dadurch gekennzeichnet, daß als Kunststoff auf Basis eines Polycarbonads ein amorphes thermoplastisches Bisphenol A-Polycarbonat verwendet wird.

22. Verfahren gemäß Anspruch 1, dadurch gekennzeichnet, daß als Kunststoff auf Basis eines Poly(Ester-CO-Carbonats) ein thermoplastisches Bisphenol A-Polycarbonat mit copolymeren Bisphenol A-Ethylenterephthalat oder Butylenterephthalat ist.

23. Verfahren gemäß Anspruch 1, dadurch gekennzeichnet, daß die Kunststoffe als Folie, als Spritzteil, als kupferlaminierte extrudierte Platte oder als Formteil vorliegen.

24. Verfahren gemäß Ansprüchen 1 bis 23 zur Herstellung von Leiterplatten.

25. Leiterplatten hergestellt nach Verfahren gemäß Ansprüchen 1 bis 23.